# EUROPÄISCHE PATENTSCHRIFT

(11) **EP 2 349 949 B1**
(45) Veröffentlichungstag und Bekanntmachung des Hinweises auf die Patenterteilung: **01.10.2014**
(21) Anmeldenummer: 09748782.1
(22) Anmeldetag: 06.11.2009
(51) Int. Cl.: C04B 35/462, C04B 35/468, C04B 35/475, H01L 41/083, H01L 41/187

(54) **KERAMISCHER WERKSTOFF, VERFAHREN ZUR HERSTELLUNG DES KERAMISCHEN WERKSTOFFS UND BAUELEMENT MIT DEM KERAMISCHEN WERKSTOFF**
CERAMIC MATERIAL, METHOD FOR PRODUCING SAID CERAMIC MATERIAL AND COMPONENT COMPRISING SAID CERAMIC MATERIAL
MATÉRIAU CÉRAMIQUE, PROCÉDÉ DE FABRICATION DE CE MATÉRIAU CÉRAMIQUE ET COMPOSANT COMPRENANT CE MATÉRIAU CÉRAMIQUE

(30) Priorität: 17.11.2008 DE 102008057721
(43) Veröffentlichungstag der Anmeldung: 03.08.2011
(73) Patentinhaber: Epcos AG, 81669 München (DE)
(72) Erfinder: KOUNGA NJIWA, Alain Brice, 8953 Dietikon (CH); WANG, Yongli, A-8523 Frauental (AT); PENZINGER, Irmgard, A-8530 Deutschlandsberg (AT)
(74) Vertreter: Epping - Hermann - Fischer
(86) Internationale Anmeldenummer: PCT/EP2009/064776
(87) Internationale Veröffentlichungsnummer: WO 2010/054994

(56) Entgegenhaltungen:
- ZHANG SHAN-TAO ET AL: "Giant strain in lead-free piezoceramics Bi0.5Na0.5TiO3â BaTiO3â K0.5Na0.5NbO3 system" APPLIED PHYSICS LETTERS, AIP, AMERICAN INSTITUTE OF PHYSICS, MELVILLE, NY, US LNKD- DOI:10.1063/1.2783200, Bd. 91, Nr. 11, 12. September 2007 (2007-09-12), Seiten 112906-112906, XP012099163 ISSN: 0003-6951
- SHAN-TAO ZHANG ET AL: "Lead-free piezoceramics with giant strain in the system Bi0.5Na0.5TiO3-BaTiO3K0.5Na0.5NbO3. I. Structure and room temperature properties" JOURNAL OF APPLIED PHYSICS AIP USA LNKD- DOI:10.1063/1.2838472, Bd. 103, Nr. 3, 1. Februar 2008 (2008-02-01), Seiten 034107-1, XP002577082 ISSN: 0021-8979
- GRANZOW T ET AL: "Field-induced phase transitions in Bismuth-based perovskites: A new approach to lead-free high-strain piezoceramics" APPLICATIONS OF FERROELECTRICS, 2008. ISAF 2008. 17TH IEEE INTERNATIONAL SYMPOSIUM ON THE, IEEE, PISCATAWAY, NJ, USA, 23. Februar 2008 (2008-02-23), Seiten 1-2, XP031367415 ISBN: 978-1-4244-2744-4

## Beschreibung

Die Erfindung betrifft einen keramischen Werkstoff und ein Verfahren zur Herstellung des keramischen Werkstoffs. Weiterhin betrifft die Erfindung ein Bauelement, das den keramischen Werkstoff umfasst, sowie die Verwendung des Bauelements.

Werkstoffe, die bei einem bestimmten angelegten elektrischen Feld eine Veränderung ihrer räumlichen Ausdehnung oder bei angelegter mechanischer Last elektrische Ladung erzeugen und damit piezoelektrische Eigenschaften aufweisen, werden beispielsweise in Aktoren oder Sensoren eingesetzt. Für diese Anwendung sind hohe Dehnungen des Werkstoffs als Antwort auf relativ niedrige angelegte elektrische Felder bzw. große Ladungen bei relativ niedrigen mechanischen Lasten erwünscht. Herkömmliche piezoelektrische Werkstoffe wie beispielsweise (PbZr)TiO₃ enthalten einen hohen Anteil, beispielsweise von 60%, von Blei, was für Mensch und Umwelt schädlich ist.

Die Druckschrift Zhang Shan-Tao et al "Giant strain in lead-free piezoceramics Bi0,5Na0,5TiO3-BaTiO3-K0,5Na0,5NbO3 system", Appl. Phys. Lett. 91, 112906 (2007) betrifft bleifreie Keramiken für piezoelektrische Aktoren, die die allgemeine Formel (0,94-x)Bi_{0,5}Na_{0,5}TiO₃-0,06BaTiO₃-xK_{0,5}Na_{0,5}NbO₃ mit 0 ≤ x ≤ 0,11 aufweisen.

In der Druckschrift Zhang Shan-Tao et al "Lead-free piezoceramics with giant strain in the system Bi0,5Na0,5TiO3-BaTiO3-K0,5Na0,5NbO3. I. Structure and room temperature properties", J. Appl. Phys. 103, 034107 (2008) wird eine bleifreie Piezokeramik der Form (1-x-y) Bi_{0,5}Na_{0,5}TiO₃-xBaTiO₃-yK_{0,5}Na_{0,5}NbO₃ mit 0,05 ≤ x ≤ 0,07 und 0,01 ≤ y ≤ 0,03 offenbart.

Die Druckschrift Granzow T. et al "Field-induced phase transitions in Bismuth-based perovskites: a new approach to lead-free high-strain piezoceramics", 17th IEEE Int. Symp. on the Application of Ferroelectrics, 2008 offenbart bleifreie Piezokeramiken der Form (1-x-y) Bi_{0,5}Na_{0,5}TiO₃-xBaTiO₃-yK_{0,5}Na_{0,5}NbO₃ mit 0,05 ≤ x ≤ 0,07 und 0,01 ≤ y ≤ 0,03.

Aufgabe der Erfindung ist es, einen neuen keramischen Werkstoff mit piezoelektrischen Eigenschaften bereitzustellen, der einen hohen piezoelektrischen Koeffizienten aufweist. Diese Aufgabe wird durch einen Werkstoff gemäß Anspruch 1 gelöst. Gegenstand weiterer Ansprüche sind Ausführungsformen des keramischen Werkstoffs, ein Herstellungsverfahren für den keramischen Werkstoff, ein Bauelement mit dem keramischen Werkstoff sowie die Verwendung des Bauelements.

In einer Ausführungsform wird ein keramischer Werkstoff bereitgestellt, der die Formel [(Bi_{0,5}Na_{0,5}TiO₃)_{(1-y)} (BaTiO₃)_{y}]₍₁₋ₓ₎ (K_{0/5}Na_{0,5}NbO₃)ₓ mit 0 < x ≤ 0,12 und 0,1 ≤ y ≤ 0,5 aufweist. Der Werkstoff weist ein ternäres System auf, wobei ternär bedeutet, dass der keramische Werkstoff aus drei Komponenten, Bismutnatriumtitanat Bi_{0,5}Na_{0,5}TiO₃ (BNT), Bariumtitanat BaTiO₃ (BT) und Kaliumnatriumniobat K_{0,5}Na_{0,5}NbO₃ (KNN) zusammengesetzt ist, wobei die Anteile der drei Komponenten je nach eingesetzten Parametern x und y variabel sind.

Der Werkstoff kann weiterhin frei von Blei sein. Somit wird der Einsatz des toxischen Bleis, beispielsweise in Aktoren oder Sensoren, vermieden und der Umgang mit dem Werkstoff erleichtert. Damit können beispielsweise elektronische Bauelemente mit diesem Werkstoff hergestellt werden, die für Mensch und Umwelt unbedenklich sind.

In den Werkstoff können KNN und BNT_{(1-y)}BT_{y} als zwei Basiskomponenten betrachtet werden, wobei KNN eine orthorhombische Kristallstruktur und BNT_{(1-y)}BT_{y} bei y ≥ 0,07 eine tetragonale Kristallstruktur aufweisen. Der Werkstoff kann dann entweder eine orthorhombische oder eine tetragonale oder auch beide Kristallstrukturen aufweisen.

Bei der Zugabe von KNN in BNT_{(1-y)}BT_{y} nimmt die Anzahl der Kationen im System zu, wobei die Verteilung der Kationen innerhalb einer Einheitszelle nicht regelmäßig ist. Dies führt zu einer Entstehung von lokalen Zufallsfeldern im Werkstoff. Wird die Konzentration von KNN in dem System [(Bi_{0,5}Na_{0,5}TiO₃)_{(1-y)}(BaTiO₃)_{y}]₍₁₋ₓ₎(K_{0,5}Na_{0,5}NbO₃)ₓ (im Folgenden [BNT_{(1-y)}(BT)_{y}]₍₁₋ₓ₎(KNN)ₓ) erhöht, so nehmen die Unregelmäßigkeit und somit die Anzahl der Zufallsfelder zu, so dass ab einer bestimmten KNN-Konzentration die Zufallsfelder jede im Werkstoff induzierte Polarisierung zerstören. Bei jedem Polarisationsvorgang des Werkstoffes wird eine Polarisation induziert, die jedoch verschwindet, sobald das angelegte elektrische Feld abgeschaltet wird. Dadurch weist der keramische Werkstoff weder eine remanente Polarisation noch eine remanente Dehnung, also eine Polarisation oder eine Dehnung die nach Abschalten des elektrischen Feldes vorhanden ist, auf. Folglich ist die sogenannte unipolare Dehnung gleich der Polungsdehung (die Dehnung die bei dem ersten Polungsvorgang des Werkstoffes erzeugt wird) und im Vergleich zu herkömmlichen Piezokeramiken, die eine einmalige Polungsdehung aufweisen, wieder herstellbar.

Bei der Messung einer unipolaren Dehnung wird das elektrische Feld folgendermaßen variiert: 0 kv/mm → Eₘₐₓ → 0 kv/mm. Bei der Messung einer bipolaren Dehnung wird das elektrische Feld folgendermaßen variiert: 0 kV/mm → Eₘₐₓ → 0 kv/mm → -Eₘₐₓ → 0 kV/mm.

Der Werkstoff weist erhöhte piezoelektrische Eigenschaften auf, wie beispielsweise einen hohen piezoelektrischen Koeffizienten von bis zu 700 pm/V bei einem elektrischen Feld von beispielsweise 2,8 kV/mm auf. Der piezoelektrische Koeffizient gibt dabei das Verhältnis zwischen der gemessenen Dehnung und dem angelegten elektrischen Feld an. Auch der piezoelektrische Koeffizient, der bei kleinen elektrischen Feldern gemessen wird, kann bei dem Werkstoff Werte von bis zu 150 pC/N betragen.

In einer Ausführungsform kann bei dem Werkstoff x = 0,09 und y = 0,2 sein. In weiteren Ausführungsformen kann x = 0,085 und y = 0, 3, x = 0,1 und y = 0,15, x = 0,075 und y = 0, 4, x = 0,07 und y = 0,5 und x = 0,06 und y = 0,1 sein. Für die Zusammensetzungen mit x = 0,1 und y = 0,15, x = 0,06 und y = 0, 1, x = 0,09 und y = 0,2, x = 0,085 und y = 0, 3, x = 0,075 und y = 0,4 und x = 0,07 und y = 0,5 weist der keramische Werkstoff besonders hohe piezoelektrische Koeffizienten bei großen Signalen von bis zu 700 pm/V auf und ist damit beispielsweise geeignet für die Anwendung in Aktoren. Für andere Zusammensetzungen kann der Werkstoff große piezoelektrische Koeffizienten bei kleinen Signalen von bis zu 150 pC/N aufweisen. Diese Werkstoffe sind damit gut geeignet für die Verwendung in Sensoren.

Es wird weiterhin ein Verfahren zur Herstellung eines Werkstoffs mit den oben genannten Eigenschaften bereitgestellt. Das Verfahren umfasst die Verfahrensschritte
A) Vermischen von pulverförmigen, sauerstoffhaltigen Verbindungen von Bi, Na, K, Ti, Ba und Nb im stöchiometrischen Verhältnis zur Herstellung einer Ausgangsmischung,
B) Mahlen und Kalizinieren der Ausgangsmischung zur Herstellung einer pulverförmigen festen Lösung, und
C) Pressen und Sintern der pulverförmigen festen Lösung.

Damit kann der Werkstoff beispielsweise mit einem Mischoxidverfahren hergestellt werden, wobei das stöchiometrische Verhältnis so gewählt wird, dass ein Werkstoff der Zusammensetzung [(Bi_{0,5}Na_{0,5}TiO₃)_{(1-y)}(BaTiO₃)_{y}]₍₁₋ₓ₎(K_{0,5}Na_{0,5}NbO₃)ₓ mit 0 < x ≤ 0,12 und 0,1 ≤ y ≤ 0,5 hergestellt wird.

In dem Verfahren können im Verfahrensschritt A) Ausgangsmaterialien aus einer Gruppe ausgewählt werden, die Oxide und Carbonate von Bi, Na, K, Ti, Ba und Nb umfasst. Es können beispielsweise Bi₂O₃, Na₂CO₃, K₂CO₃, TiO₂, BaCO₃ und Nb₂O₅ ausgewählt werden. Diese Verbindungen werden gemäß dem gewünschten stöchiometrischen Verhältnis abgewogen und gemischt.

Weiterhin kann im Verfahrensschritt B) die Ausgangsmischung in einem Lösungsmittel gemahlen, getrocknet und bei einer Temperatur, die einen Bereich von 800°C bis 950°C umfasst, kaliziniert werden. Als Lösungsmittel kann dabei beispielsweise wasserfreies Ethanol gewählt werden, und das Kalzinieren beispielsweise bei einer Temperatur von 900°C bei einer Haltezeit von beispielsweise drei Stunden durchgeführt werden.

Weiterhin kann im Verfahrensschritt C) die pulverförmige feste Lösung gemahlen werden, beispielsweise während einer Zeit von 24 Stunden. Die gemahlene pulverförmige feste Lösung kann in Scheiben gepresst werden, die Grünkörper sind, und bei einer Temperatur gesintert werden, die einen Bereich von 1150°C bis 1200°C umfasst. Die gepressten Scheiben können beispielsweise einen Durchmesser von 15 mm umfassen und bei 70 MPa gepresst werden. Die Sintertemperatur kann beispielsweise 1150°C betragen und in einem aluminiumbeschichteten Behälter durchgeführt werden. Um ein Verflüchtigen der leicht flüchtigen Elemente Bismut, Natrium und Kalium zu reduzieren, können die gepressten Scheiben während der Sinterung in den entsprechenden Pulvern eingebettet werden. Die Dichte des gesinterten Werkstoffs kann zwischen 95% und 98% der theoretischen Dichte betragen.

Es wird weiterhin ein Bauelement bereitgestellt, das zumindest einen keramischen Grundkörper und zumindest zwei auf dem Grundkörper angeordnete Elektroden aufweist, wobei die Keramikschicht einen Werkstoff mit den oben genannten Eigenschaften aufweist. Das Bauelement kann weiterhin einen Grundkörper umfassen, der eine Vielzahl von gestapelten Keramikschichten mit dazwischen angeordneten Elektroden umfasst, wobei die Elektroden über auf der Außenfläche des Grundkörpers angeordneten Außenelektroden elektrisch kontaktiert sind. Die Elektroden können beispielsweise wechselseitig kontaktiert werden. Dadurch können Bauelemente bereitgestellt werden, die bei Anlegen einer Spannung eine Dehnung in eine Richtung (Auslenkung) aufweisen.

Ein solches Bauelement kann beispielsweise als Piezoaktor oder Vielschichtaktor verwendet werden. Ein Piezoaktor kann beispielsweise für Einspritzsysteme eingesetzt werden. Weiterhin kann das Bauelement mit den oben genannten Eigenschaften als Sensor zur Detektion von Drücken und Beschleunigungen verwendet werden. Es sind aber auch weitere Verwendungsmöglichkeiten mit einem der oben genannten Werkstoffe denkbar.

Anhand der Figuren und Ausführungsbeispiele soll die Erfindung näher erläutert werden:
Figur 1 zeigt eine Übersicht über mögliche Zusammensetzungen des ternären Systems des keramischen Werkstoffs,
Figur 2 zeigt a) Polarisationshysteresen und b) die bipolare Dehnungshysteresen von beispielhaften Werkstoffen mit y = 0.1,
Figur 3 zeigt a) Polarisationshysteresen und b) bipolare Dehnungshysteresen von beispielhaften Werkstoffen mit y = 0.15,
Figur 4 zeigt a) Polarisationshysteresen und b) bipolare Dehnungshysteresen von beispielhaften Werkstoffen mit y = 0.2,
Figur 5 zeigt a) Polarisationshysteresen und b) bipolare Dehnungshysteresen von beispielhaften Werkstoffen mit y = 0.3,
Figur 6 zeigt a) Polarisationshysteresen und b) bipolare Dehnungshysteresen von beispielhaften Werkstoffen mit y = 0.4,
Figur 7 zeigt a) Polarisationshysteresen und b) bipolare Dehnungshysteresen von beispielhaften Werkstoffen mit y = 0.5,
Figur 8 zeigt die Abhängigkeit von der Zusammensetzung des Werkstoffs a) der maximalen Polarisation, b) der remanenten Polarisation und c) des Koerzitivfeldes,
Figur 9 zeigt den piezoelektrischen Koeffizienten in Abhängigkeit der Zusammensetzung des Werkstoffs a) bei großen elektrischen Feldern und b) bei kleinen elektrischen Feldern und kleinen mechanischen Belastungen,
Figur 10 zeigt die temperaturabhängige relative Permittivität von verschiedenen Zusammensetzungen des Werkstoffs für a) y = 0, 1, b) y = 0,15, c) y = 0,2, d) y = 0,3, e) y = 0,4 und f) y = 0,5,
Figur 11 zeigt die schematische Seitenansicht eines Bauelements mit dem Werkstoff.

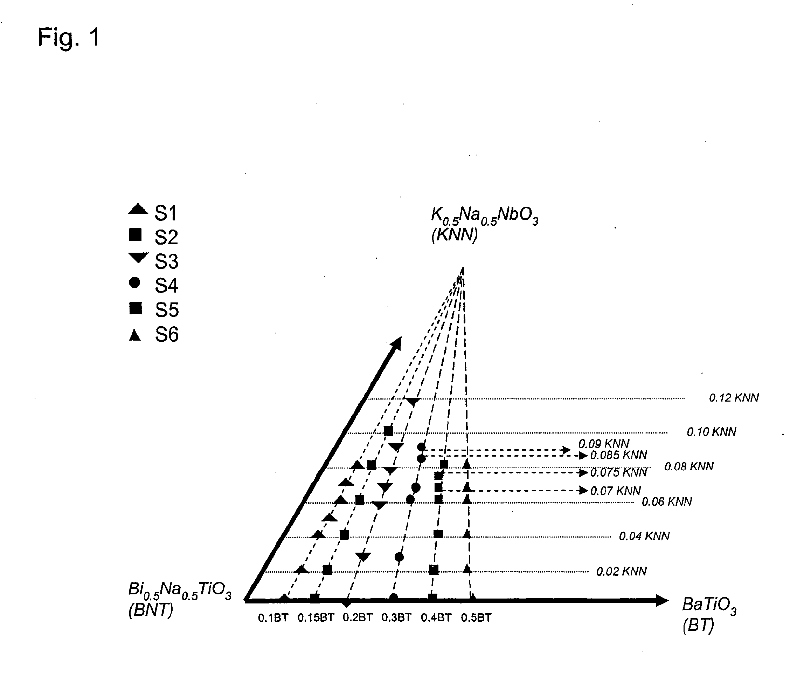

Figur 1 zeigt eine Übersicht über mögliche Zusammensetzungen des ternären Systems des keramischen Werkstoffs aus den Komponenten BNT, BT und KNN. Auf der x-Achse ist der Anteil an BT aufgetragen, woraus sich gemäß der allgemeinen Formel automatisch der BNT-Anteil berechnen lässt. Auf der y-Achse ist der KNN-Anteil aufgetragen. In dem Diagramm sind dann die konkreten Zusammensetzungen mit definierten x- und y-Werten eingetragen, wobei gleiche Symbole jeweils für eine Zusammensetzung mit gleichem y-Wert (BT- und BNT-Verhältnis) stehen, wobei der x-Wert variabel ist. Die gesamte Auftragung ist nur schematisch und nicht maßstabsgetreu zu verstehen.
S1 gibt dabei die Zusammensetzungen S1 [BNT_{0,9}(BT)_{0,1}]₍₁₋ₓ₎(KNN)ₓ an, in der y = 0,1 ist. In dem Diagramm ist die Zusammensetzung S1 für x = 0 (als Referenz), x = 0, 02, x = 0, 04, x = 0, 05, x = 0,06, x = 0, 07 und x = 0,08 eingezeichnet.
S2 gibt dabei die Zusammensetzungen [BNT_{0,85}(BT)_{0,15}]₍₁₋ₓ₎(KNN)ₓ an, in der y = 0,15 ist. In dem Diagramm ist die Zusammensetzung S2 für x = 0 (als Referenz), x = 0,02, x = 0,04, x = 0,06, x = 0,08 und x = 0,1 eingezeichnet.
S3 gibt dabei die Zusammensetzungen [BNT_{0,8}(BT)_{0,2}]₍₁₋ₓ₎(KNN)ₓ an, in der y = 0,2 ist. In dem Diagramm ist die Zusammensetzung S3 für x = 0 (als Referenz), x = 0, 03, x = 0,06, x = 0, 07, x = 0,08, x = 0, 09 und x = 0,12 eingezeichnet.
S4 gibt dabei die Zusammensetzungen [BNT_{0,7}(BT)_{0,3}]₍₁₋ₓ₎(KNN)ₓ an, in der y = 0,3 ist. In dem Diagramm ist die Zusammensetzung S4 für x = 0 (als Referenz), x = 0,03, x = 0,06, x = 0,07, x = 0,085, und x = 0,09 eingezeichnet.
S5 gibt dabei die Zusammensetzungen [BNT_{0,6}(BT)_{0,4}]₍₁₋ₓ₎(KNN)ₓ an, in der y = 0,4 ist. In dem Diagramm ist die Zusammensetzung S5 für x = 0 (als Referenz), x = 0,02, x = 0,04, x = 0,06, x = 0, 07, x = 0, 075 und x = 0,08 eingezeichnet.
S6 gibt dabei die Zusammensetzungen [BNT_{0,5}(BT)_{0,5}]₍₁₋ₓ₎(KNN)ₓ an, in der y = 0,5 ist. In dem Diagramm ist die Zusammensetzung S6 für x = 0 (als Referenz), x = 0,02, x = 0,04, x = 0,06, x = 0,07 und x = 0,08 eingezeichnet.

Im Rahmen der oben angegebenen allgemeinen Formel des keramischen Werkstoffs sind auch weitere, hier nicht aufgeführte Zusammensetzungen möglich.

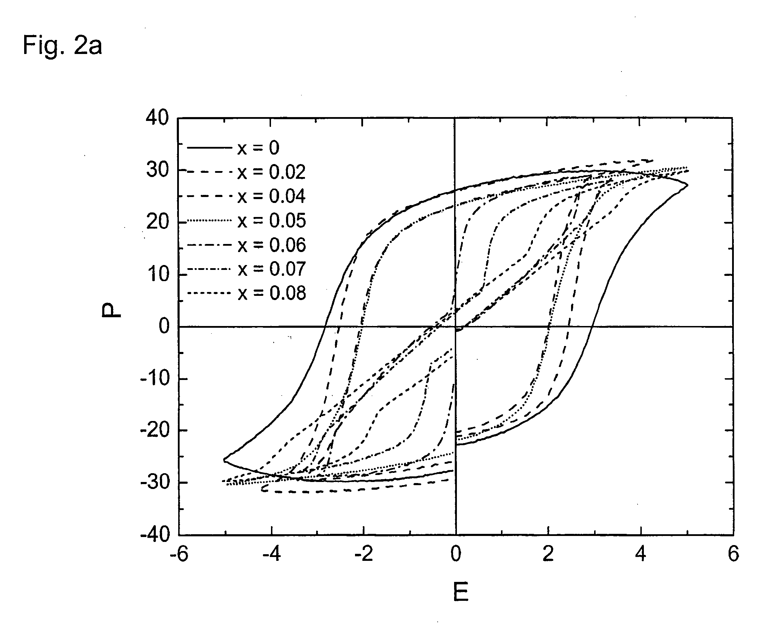

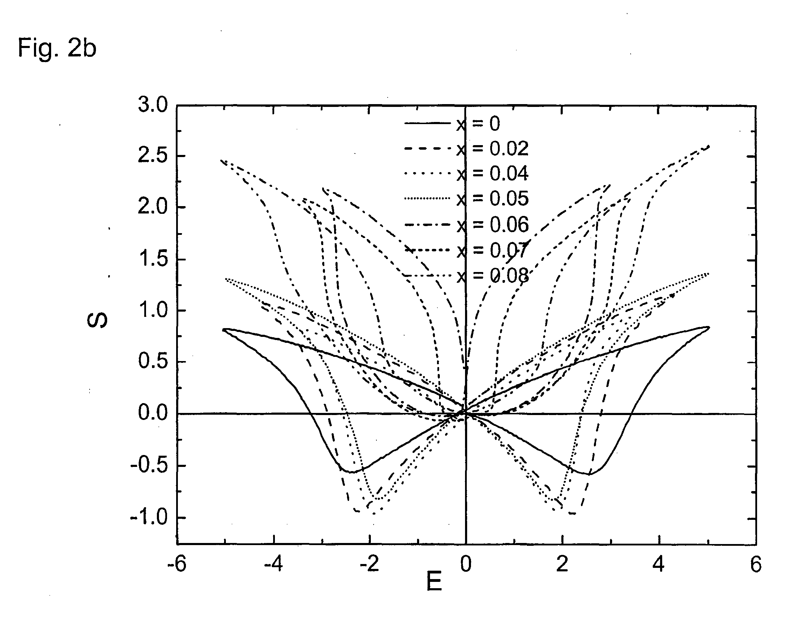

In den Figuren 2 bis 7 sind die Messdaten von folgenden Zusammensetzungen gezeigt:
- Figuren 2a und 2b:: Zusammensetzungen S1,

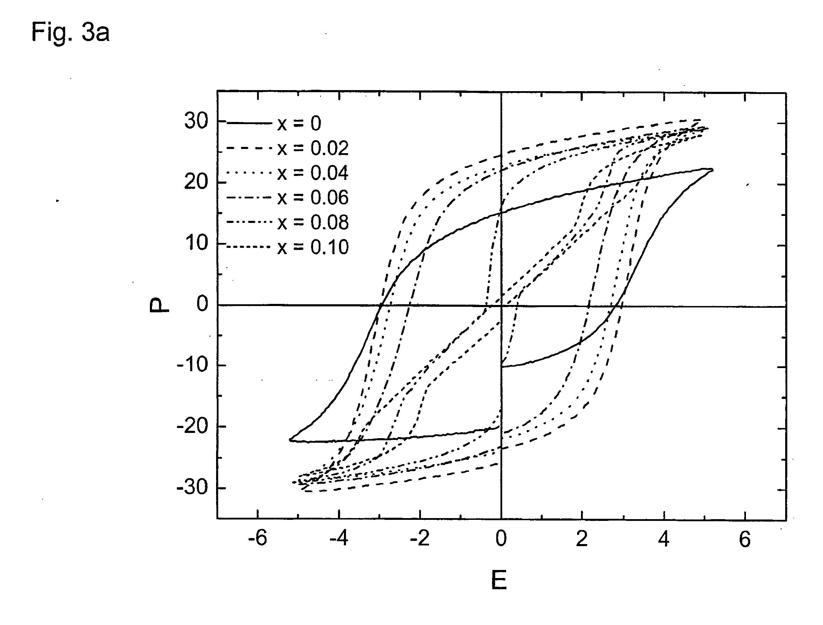

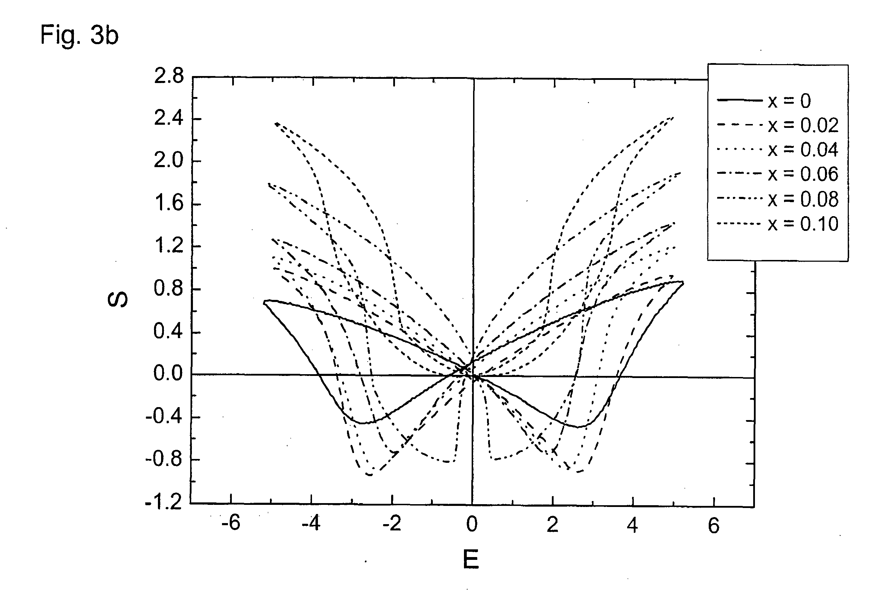

- Figuren 3a und 3b:: Zusammensetzungen S2,

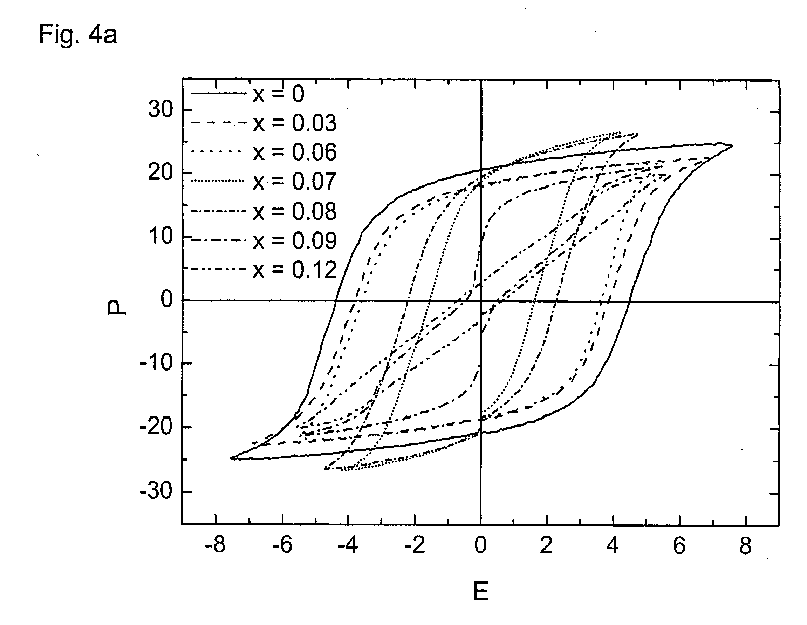

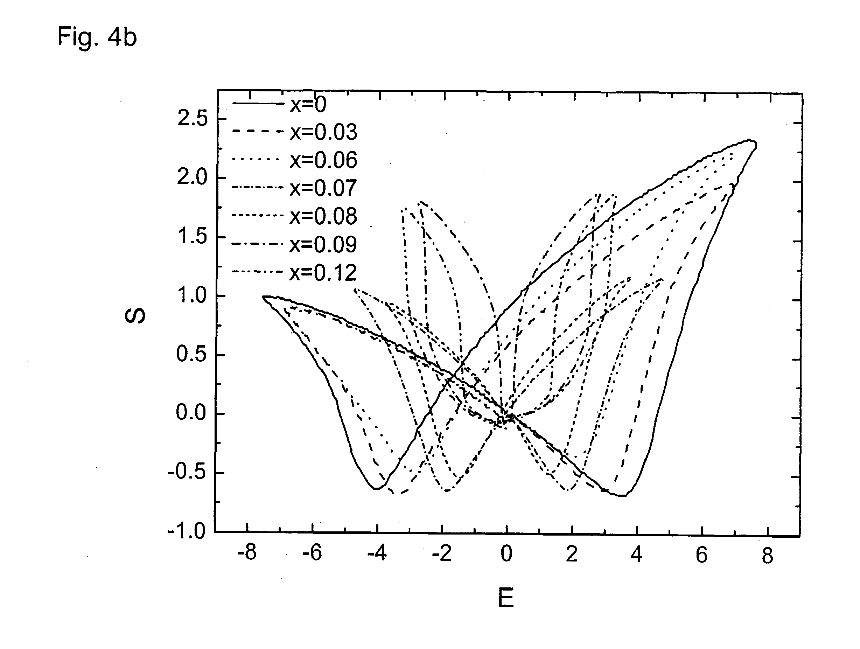

- Figuren 4a und 4b:: Zusammensetzungen S3 (der Übersichtlichkeit halber werden die Daten für x = 0,07 und x = 0,08 nicht gezeigt),

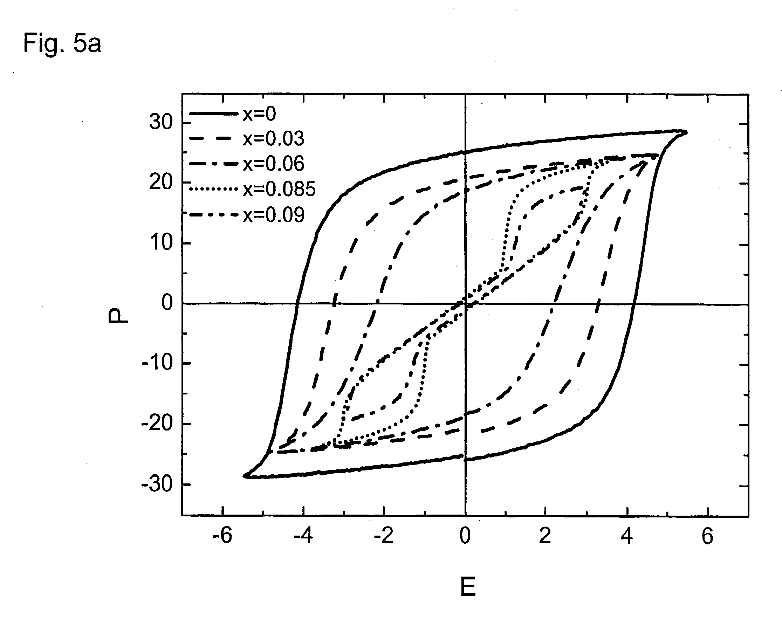

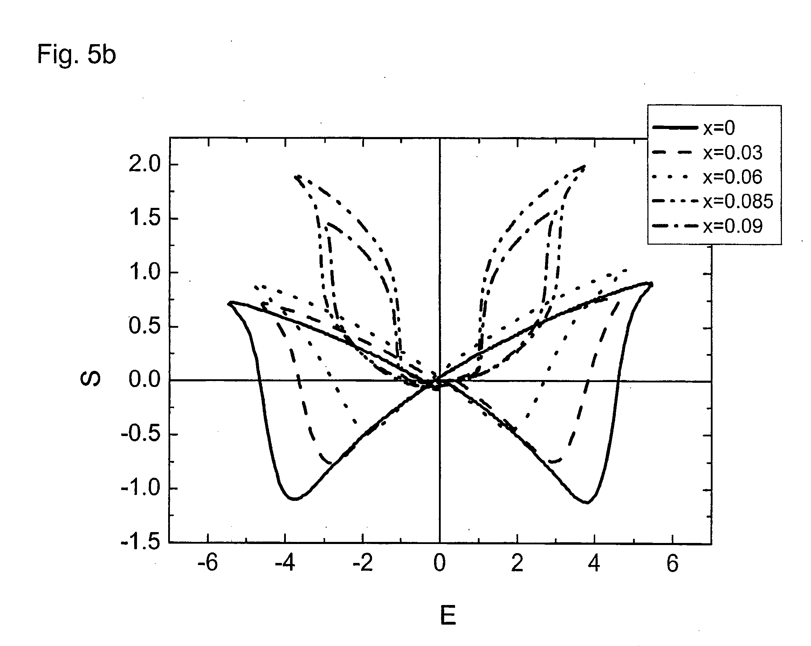

- Figuren 5a und 5b:: Zusammensetzungen S4 (der Übersichtlichkeit halber werden die Daten für x = 0,07 nicht gezeigt),

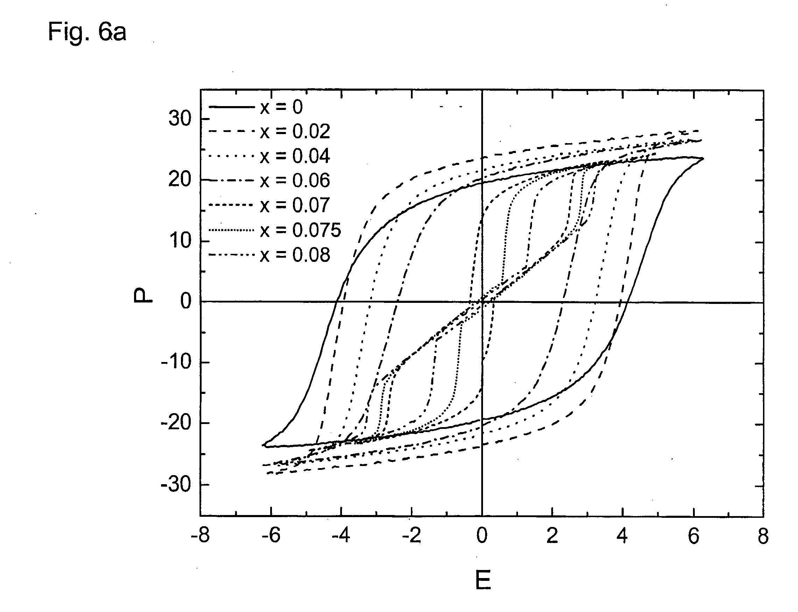

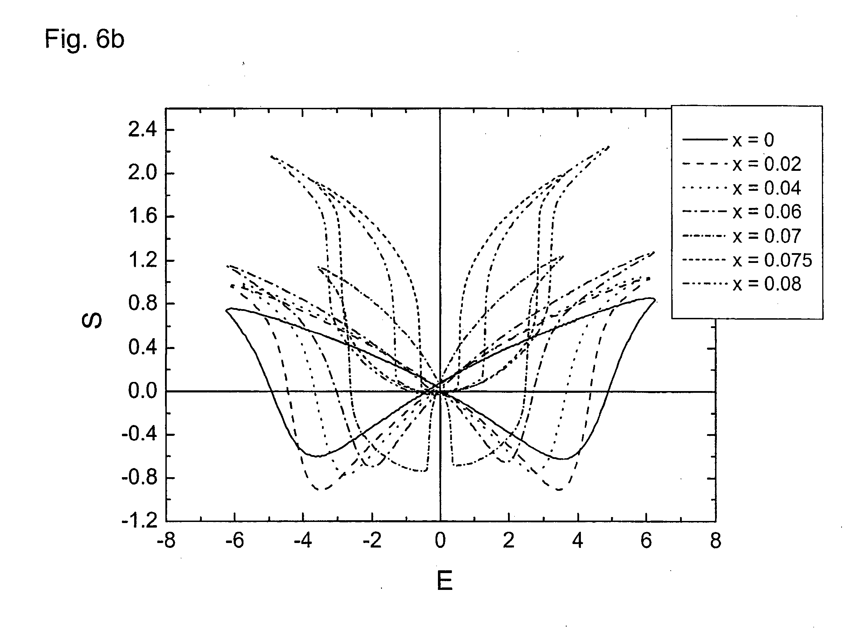

- Figuren 6a und 6b:: Zusammensetzungen S5,

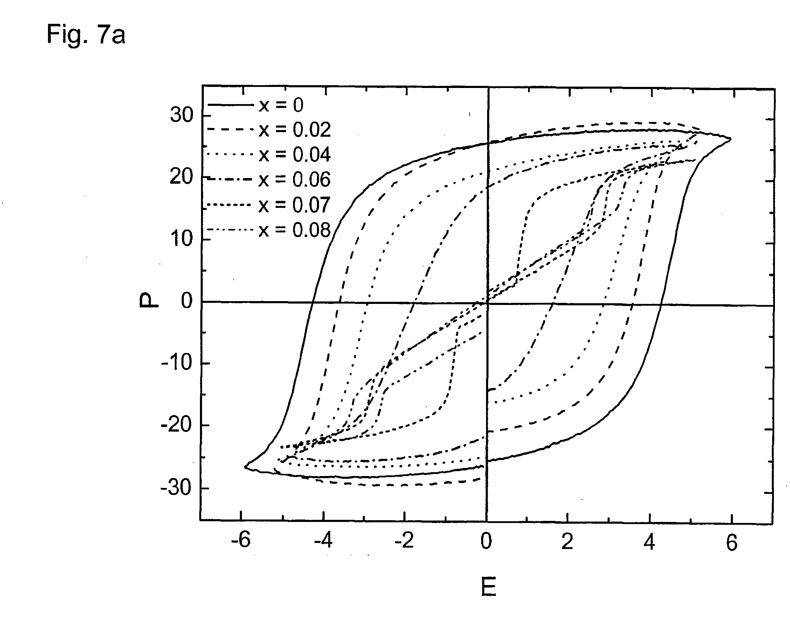

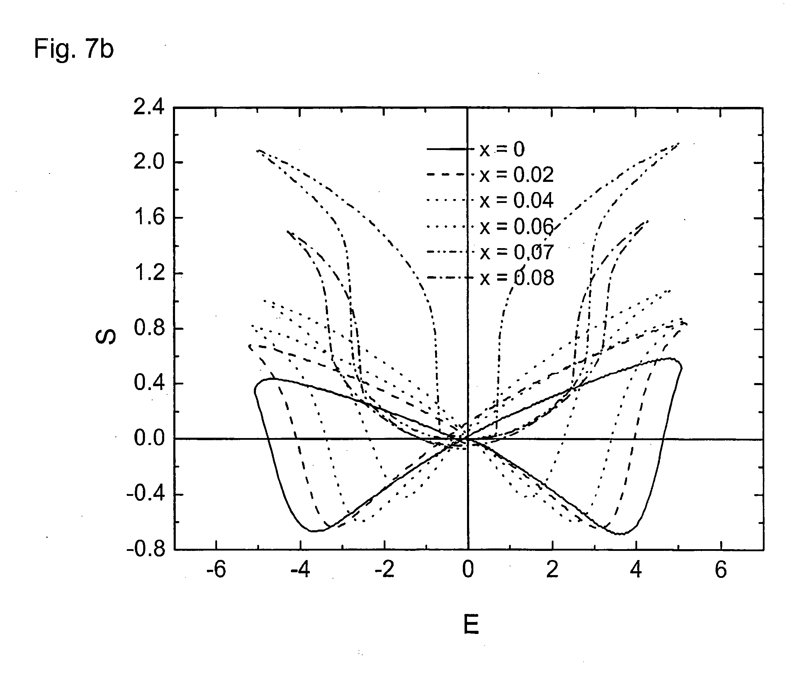

- Figuren 7a und 7b:: Zusammensetzungen S6.

Die elektrischen Messungen an dem Werkstoff, die in den folgenden Figuren 2a, 3a, 4a, 5a, 6a und 7a gezeigt werden, wurden an gesinterten Scheiben-Proben des jeweiligen Werkstoffs durchgeführt. Auf den breiten Scheibenflächen wird vor den Messungen eine dünne Silberschicht aufgebracht und für 30 Minuten bei 500°C getrocknet. Dadurch werden Silberschichten erhalten, die als Elektroden für die elektrischen Messungen dienen.

In den Figuren 2a, 3a, 4a, 5a, 6a und 7a ist teilweise ein Versatz in den Hysteresekurven erkennbar. Dieser Versatz kann durch teilweise Entladung des Meßkondensators oder durch eine geringe Leitfähigkeit der Probe, die durch angepasste Sinterung behoben werden kann, bedingt sein.

Die Figuren 2a, 3a, 4a, 5a, 6a und 7a zeigen die Polarisationshysteresen für die jeweiligen Zusammensetzungen S1 bis S6. Dabei ist jeweils die angelegte Feldstärke E in kV/mm gegen die Polarisation P in µC/cm² aufgetragen. Für die Messung wird ein elektrisches Feld mit dreieckiger Wellenform und mit einer Frequenz von 50 mHz gewählt und die Messung bei Raumtemperatur durchgeführt.

Es ist zu sehen, dass mit größer werdendem x die Koerzitivfeldstärke E_{c}, die elektrische Feldstärke bei P = 0, abnimmt. Bei einem Feld von E = 4 kV/mm bis 8 kV/mm (abhängig von der untersuchten Zusammensetzung) wird eine Sättigung der Polarisation erreicht.

Die Figuren 2b, 3b, 4b, 5b, 6b und 7b zeigen bipolare Dehnungshysteresen für die untersuchten Zusammensetzungen S1 bis S6. Diese Messungen werden simultan mit den Messungen der Polarisationshysteresen durchgeführt. In den Figuren ist die bipolare Dehnung S in ‰ in Abhängigkeit des angelegten elektrischen Feldes E in kV/mm für die beispielhaften Werkstoffe gezeigt. Bei einer bipolaren Messung wird das angelegte Feld E von 0 kV/mm auf 8 kV/mm erhöht, dann auf -8 kV/mm umgekehrt und schließlich wieder auf 0 kV/mm erhöht. Eine bipolare Variation des Feldes führt zu einer Dehnungskurve, die eine Schmetterlingsform aufweist.

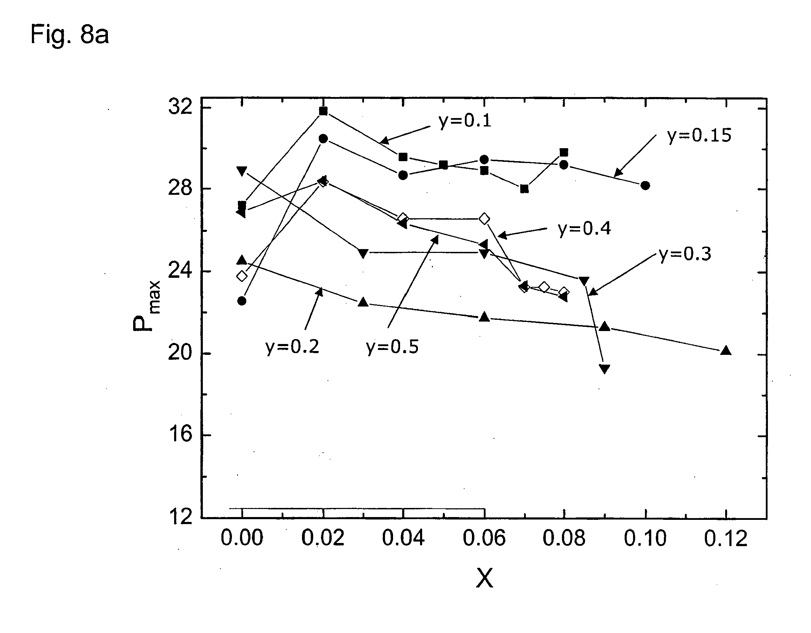

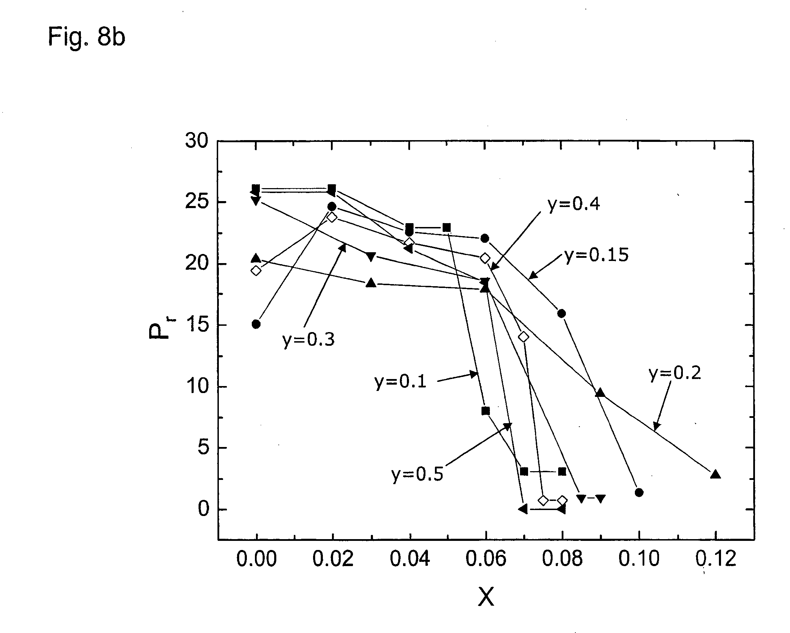

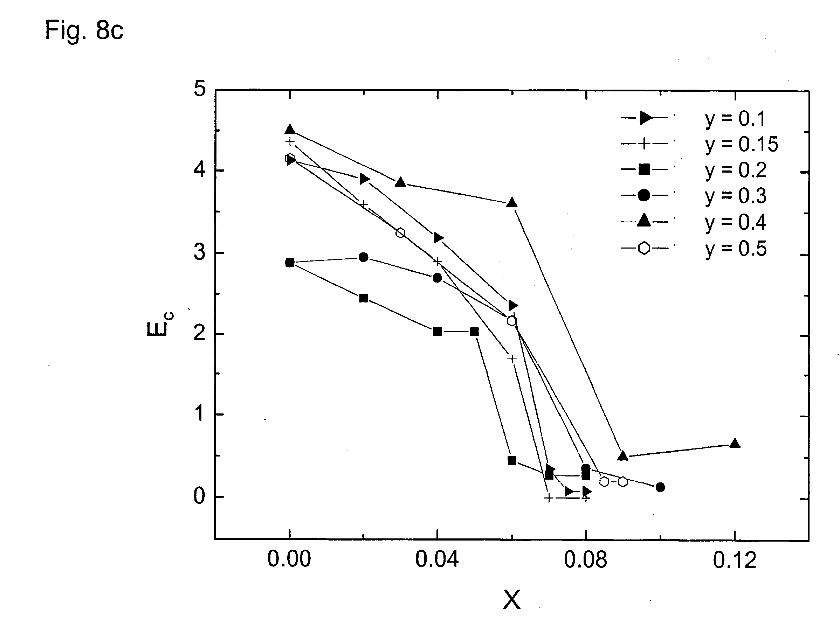

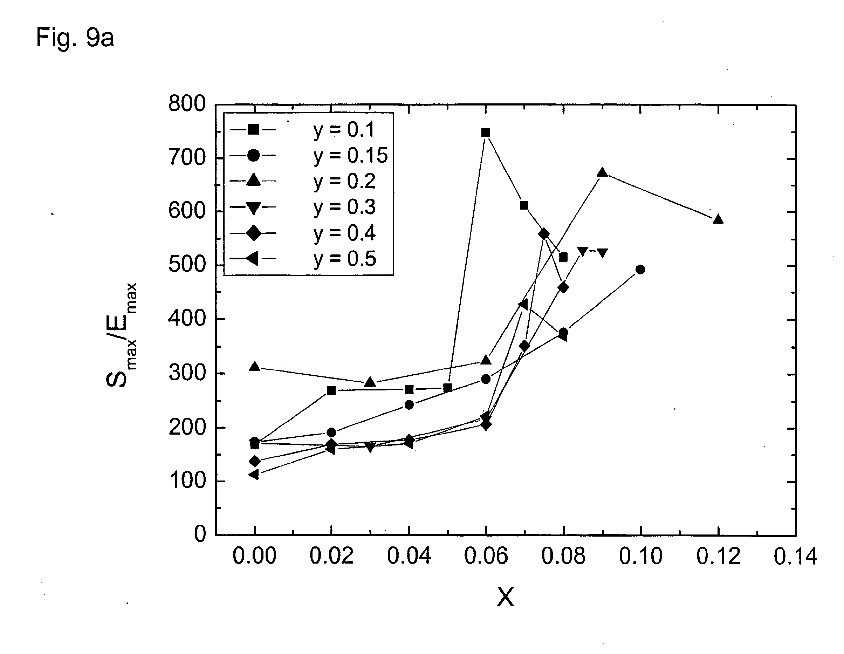

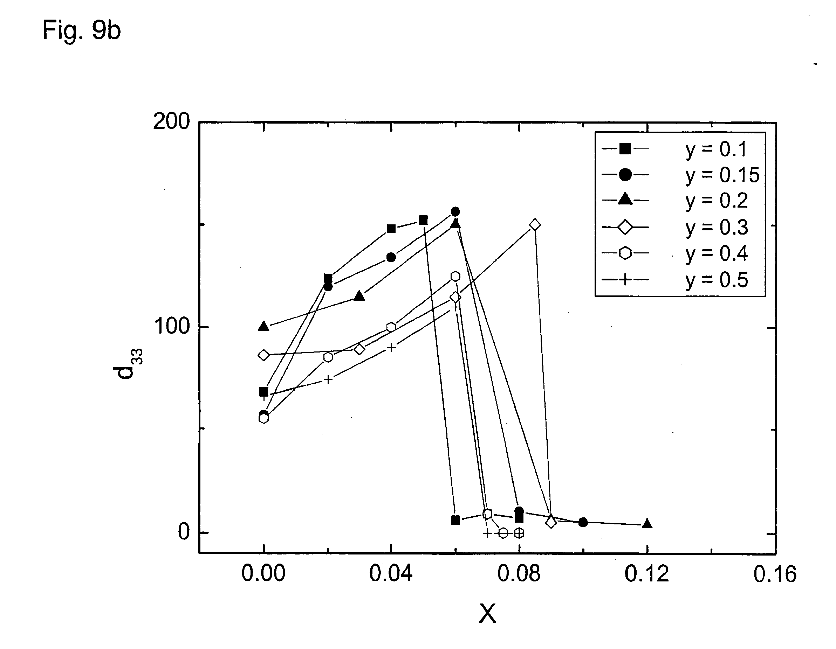

In den Figuren 8a, 8b, 8c sowie 9a und 9b sind die charakteristischen Werte für einige der untersuchten Werkstoffe zusammengefasst.

Figur 8a zeigt die maximale Polarisation Pₘₐₓ in µC/cm² in Abhängigkeit von x, also in Abhängigkeit der Zusammensetzung des Werkstoffes. Figur 8b zeigt die remanente Polarisation Pᵣ in µC/cm² (die Polarisation bei E = 0 kV/mm) in Abhängigkeit von x. In den Figuren 8a und 8b sind die Messdaten von Zusammensetzungen mit y = 0,1, y = 0,15, y = 0,2, y = 0,3, y = 0,4 und y = 0,5 angegeben. Figur 8c zeigt für diese Werkstoffe die Koerzitivfeldstärke E_{c} in kV/mm (die Feldstärke bei einer Polarisation von 0) in Abhängigkeit von x. Pₘₐₓ ist für alle Zusammensetzungen im Rahmen der Meßgenauigkeit unabhängig von x, während Pᵣ und E_{c} für x > 0,6 einen starken Abfall zeigen.

Je nach Verwendung des Werkstoffs können diese Polarisations- oder Koerzitivfeldstärkenwerte vorteilhaft sein. Beispielsweise sind hohe Werte der remanenten Polarisation gut für die Verwendung in Sensoren geeignet, während niedrige Werte für die Verwendung in Aktoren günstig sind.

Figur 9a zeigt den piezoelektrischen Koeffizienten bei großen Signalen in Form des Verhältnisses der maximalen Dehnung Sₘₐₓ zu dem maximal angelegten Feld Eₘₐₓ Sₘₐₓ/Eₘₐₓ in pm/V in Abhängigkeit der Zusammensetzung des Werkstoffs in Form von x, für y = 0,1, y = 0,15, y = 0,2, y = 0,3, y = 0,4 und y = 0,5. Es sind Werte von Sₘₐₓ/Eₘₐₓ von bis zu 700 pm/V erreichbar, was besonders gut für die Verwendung in Aktoren geeignet ist.

In Figur 9b ist der piezoelektrische Koeffizient bei kleinen Signalen d₃₃ in pC/N in Abhängigkeit der Zusammensetzung (x) für die Werkstoffe aus Figur 9a gezeigt. d₃₃ wurde bei E = 0 kV/mm mit einem Berlincourtmeter ermittelt, mit Proben, die bei einem Feld von 7 kV/mm für 5 Minuten bei Raumtemperatur gepolt wurden. Alle Zusammensetzungen, für die d₃₃ > 0 ist, sind gut geeignet für die Verwendung in Sensoren.

Bei einer temperaturabhängigen Impedanz-Messung (bei einer Temperaturvariation von 25°C bis 400°C) wird die relative dielektrische Permittivität εᵣ bei einer Frequenz von 1kHz ermittelt. Aus den Maxima der Messkurven bzw. aus den Temperaturen, bei denen die Permittivität stark ansteigt, kann die Depolarisationstemperatur ermittelt werden. Diese beträgt beispielsweise für y = 0,1 und x = 0,04 etwa 200°C oder für y = 0,2 und x = 0,03 etwa 150°C.

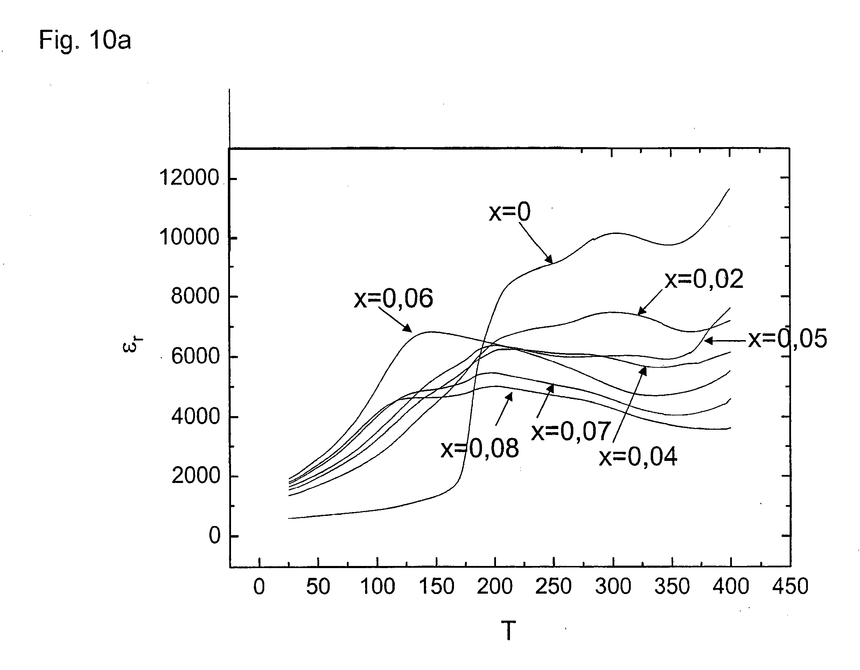

In den Figuren 10a bis 10f sind die Messdaten von folgenden Zusammensetzungen gezeigt:
- Figur 10a:: Zusammensetzungen S1,

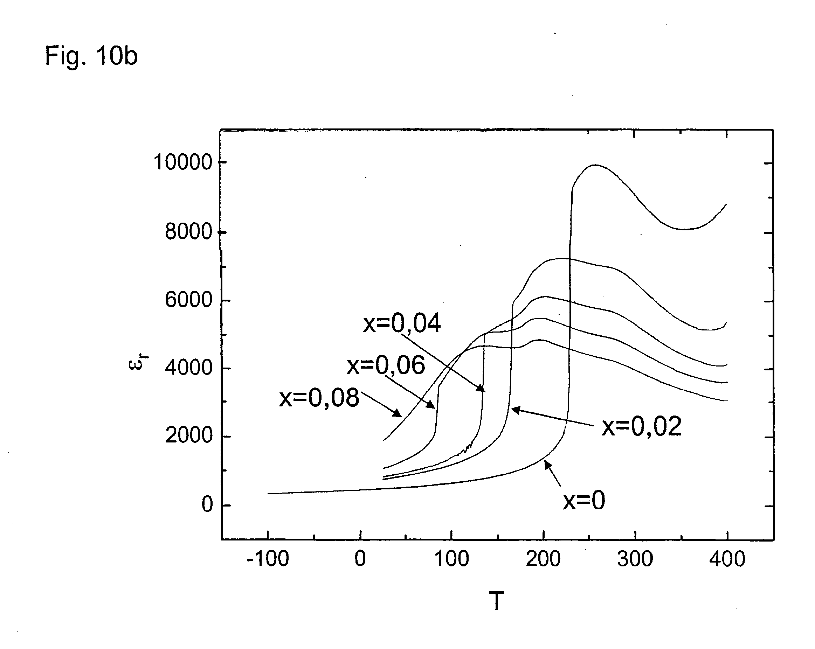

- Figur 10b:: Zusammensetzungen S2 (der Übersichtlichkeit halber werden die Daten für x = 0,1 nicht gezeigt),

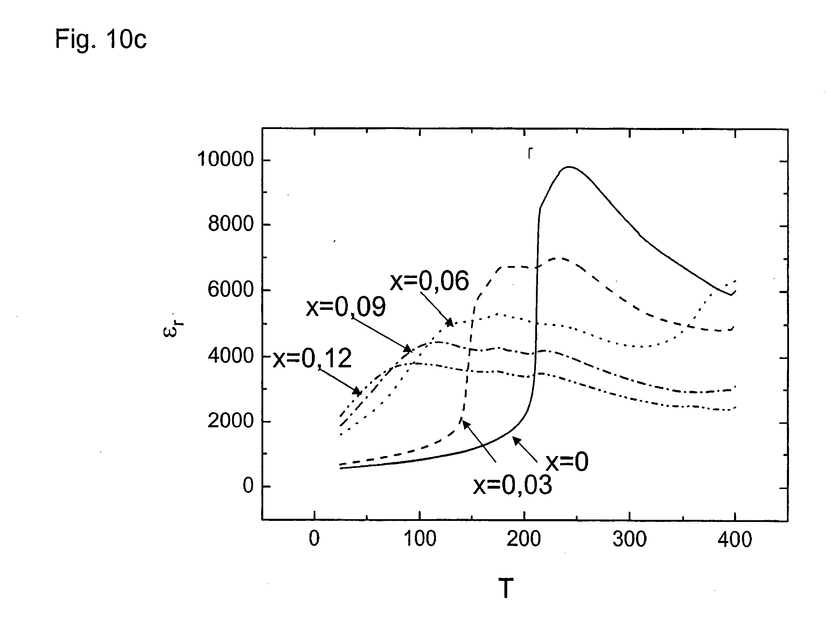

- Figur 10c:: Zusammensetzungen S3 (der Übersichtlichkeit halber werden die Daten für x = 0,07 und x = 0,08 nicht gezeigt),

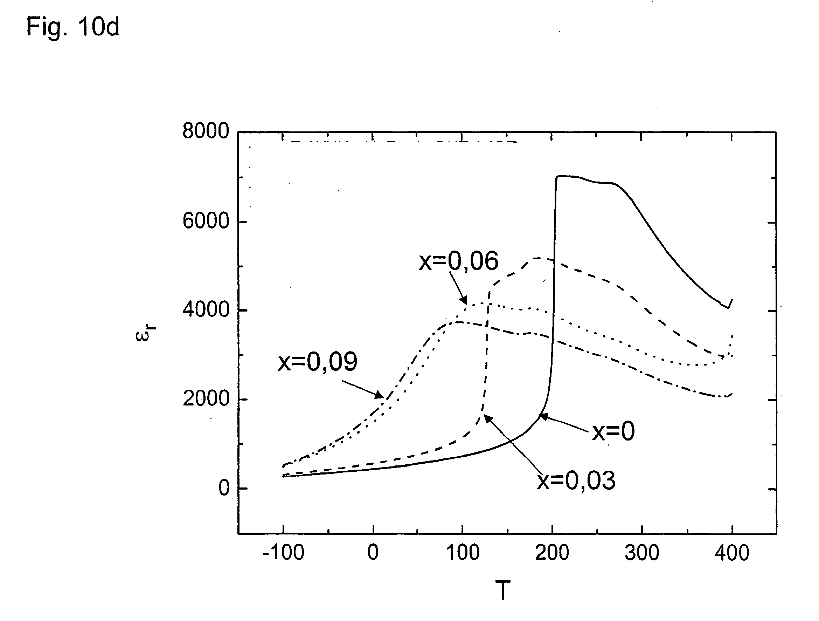

- Figur 10d:: Zusammensetzungen S4 (der Übersichtlichkeit halber werden die Daten für x = 0,07 und x = 0,085 nicht gezeigt),

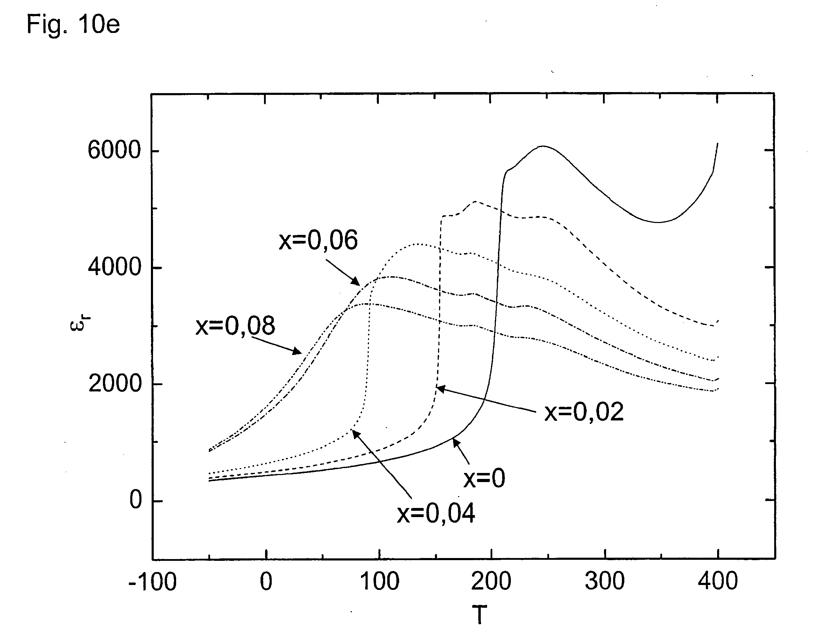

- Figur 10e:: Zusammensetzungen S5 (der Übersichtlichkeit halber werden die Daten für x = 0,07 und x = 0,075 nicht gezeigt),

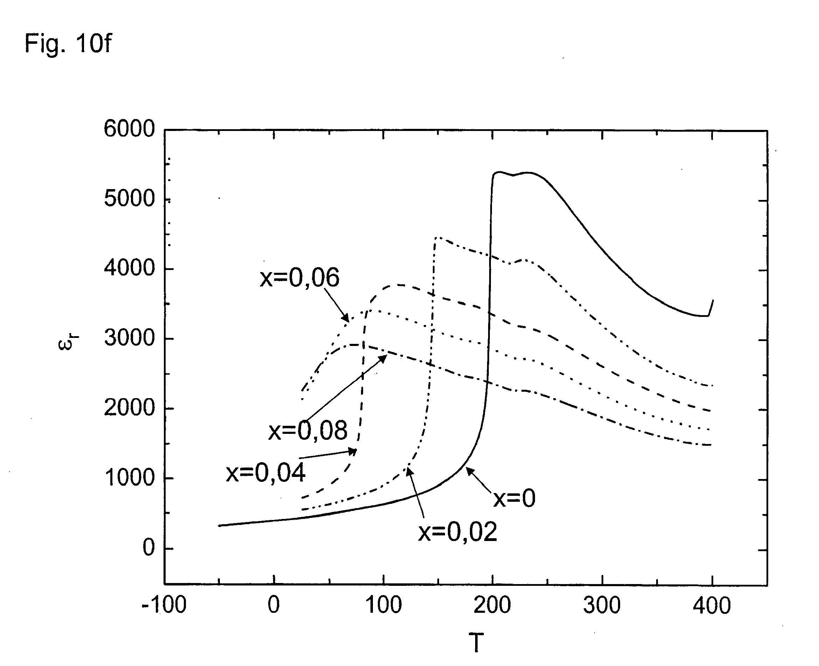

- Figur 10f:: Zusammensetzungen (der Übersichtlichkeit halber werden die Daten für x = 0,07 nicht gezeigt).

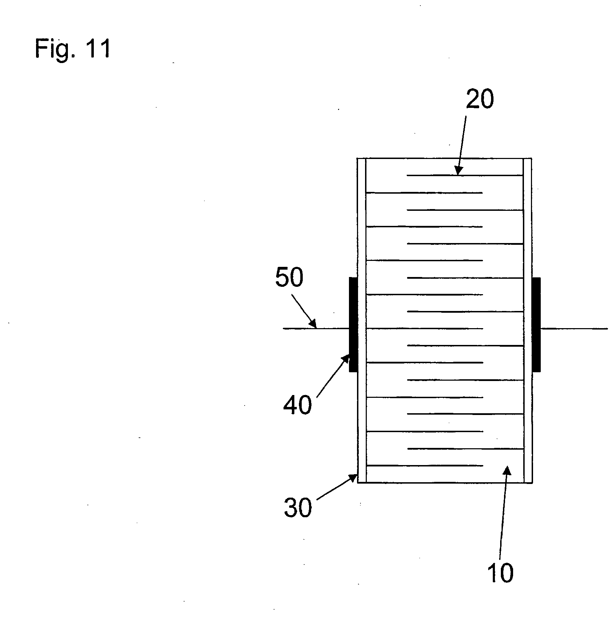

Figur 11 zeigt die schematische Seitenansicht eines Bauelements, das den Werkstoff in einer der oben beschriebenen Ausführungen enthält. Das Bauelement weist einen keramischen Grundkörper 10 auf, der aus mehreren Keramikschichten aufgebaut ist, die zu einem monolithischen Grundkörper gesintert sind. Die Keramikschichten weisen den keramischen Werkstoff mit dem ternären System [(Bi_{0,5}Na_{0,5}TiO₃)_{(1-y)}(BaTiO₃)_{y}]₍₁₋ₓ₎ (K_{0,5}Na_{0,5}NbO₃)ₓ mit 0 < x ≤ 0,12 und 0,1 ≤ y ≤ 0,5 auf. Zwischen den Keramikschichten sind Elektroden 20 angeordnet. Weiterhin sind an den Seiten des Grundkörpers Außenelektroden 30 angeordnet, die die Elektroden 20 in dem Grundkörper wechselseitig kontaktieren. Auf den Außenelektroden sind Anschlusselemente 40 vorhanden, die über Leiter 50 kontaktiert sind.

Dieses Bauelement kann beispielsweise als Piezoaktor in einem Einspritzsystem verwendet werden. Wird über die Leiter 50 ein Feld angelegt, weist der Grundkörper 10 eine Dehnung auf. Bei Abschalten des Feldes geht auch die Dehnung des Grundkörpers zurück.

Die in den Figuren und Ausführungsbeispielen gezeigten Ausführungsformen können beliebig variiert werden. Es ist weiterhin zu berücksichtigen, dass sich die Erfindung nicht auf die Beispiele beschränkt, sondern weitere, hier nicht aufgeführte Ausgestaltungen zulässt.

### Bezugszeichenliste

- P: Polarisation in µC/cm²
- E: Elektrisches Feld in kV/mm
- S: Dehnung in ‰
- Pₘₐₓ: maximale Polarisation in µC/cm²
- Pᵣ: remanente Polarisation µC/cm²
- E_{c}: Koerzitivfeldstärke in kV/mm
- Sₘₐₓ/Eₘₐₓ: piezoelektrischer Koeffizient bei großen Signalen in pm/V
- d₃₃: piezoelektrischer Koeffizient bei kleinen Signalen in pC/N
- εᵣ: relative Permittivität
- T: Temperatur in °C
- S1: Zusammensetzungen [BNT_{0,9}(BT)_{0,1}]₍₁₋ₓ₎(KNN)ₓ
- S2: Zusammensetzungen [BNT_{0,85}(BT)_{0,15}]₍₁₋ₓ₎(KNN)ₓ
- S3: Zusammensetzungen [BNT_{0,8}(BT)_{0,2}]₍₁₋ₓ₎(KNN)ₓ
- S4: Zusammensetzungen [BNT₀,₇(BT)_{0,3}]₍₁₋ₓ₎(KNN)ₓ
- S5: Zusammensetzungen [BNT_{0,6}(BT)_{0,41}]₍₁₋ₓ₎(KNN)ₓ
- S6: Zusammensetzungen [BNT_{0,5}(BT)_{0,5}]₍₁₋ₓ₎(KNN)ₓ
- 10: Grundkörper
- 20: Elektroden
- 30: Außenelektroden
- 40: Anschlußelemente
- 50: Leiter

## Patentansprüche

1. Keramischer Werkstoff, aufweisend die Formel [(Bi_{0,5}Na_{0,5}TiO₃)_{(1-y)}(BaTiO₃)_{y}]₍₁₋ₓ₎(K_{0,5}Na_{0,5}NbO₃)ₓ mit 0 < x ≤ 0,12 und 0,1 ≤ y ≤ 0,5.

2. Werkstoff nach dem vorhergehenden Anspruch, der frei von Blei ist.

3. Werkstoff nach einem der vorhergehenden Ansprüche, wobei x = 0,09 und y = 0,2.

4. Werkstoff nach einem der Ansprüche 1 oder 2, wobei x = 0,085 und y = 0,3.

5. Werkstoff nach einem der Ansprüche 1 oder 2, wobei x = 0,075 und y = 0,4.

6. Werkstoff nach einem der Ansprüche 1 oder 2, wobei x = 0,07 und y = 0,5.

7. Werkstoff nach einem der Ansprüche 1 oder 2, wobei x = 0,06 und y = 0,1.

8. Verfahren zur Herstellung eines keramischen Werkstoffs, der die Formel
[(Bi_{0,5}Na_{0,5}TiO₃)_{(1-y)}(BaTiO₃)_{y}]₍₁₋ₓ₎(K_{0,5}Na_{0,5}NbO₃)ₓ mit 0 < x ≤ 0,12 und 0,1 ≤ y ≤ 0,5 aufweist, mit den Verfahrensschritten
A) Vermischen von pulverförmigen sauerstoffhaltigen Verbindungen von Bi, Na, K, Ti, Ba und Nb im stöchiometrischen Verhältnis zur Herstellung einer Ausgangsmischung,
B) Mahlen und Kalzinieren der Ausgangsmischung zur Herstellung einer pulverförmigen festen Lösung,
C) Pressen und Sintern der pulverförmigen festen Lösung.

9. Verfahren nach dem vorhergehenden Anspruch, wobei im Verfahrensschritt A) Ausgangsmaterialien aus einer Gruppe ausgewählt werden, die Oxide und Carbonate von Bi, Na, K, Ti, Ba und Nb umfasst.

10. Verfahren nach einem der Ansprüche 8 oder 9, wobei im Verfahrensschritt B) die Ausgangsmischung in einem Lösungsmittel gemahlen, getrocknet und bei einem Temperaturbereich von 800°C bis 950°C kalziniert wird.

11. Verfahren nach einem der Ansprüche 8 bis 10, wobei im Verfahrensschritt C) die gemahlene pulverförmige feste Lösung in Scheiben gepresst wird und bei einer Temperatur gesintert wird, die einen Bereich von 1150°C bis 1200°C umfasst.

12. Bauelement, das zumindest einen keramischen Grundkörper und zumindest zwei auf dem Grundkörper angeordnete Elektroden aufweist, wobei der Grundkörper einen keramischen Werkstoff, der die Formel [(Bi_{0,5}Na_{0,5}TiO₃)_{(1-y)}(BaTiO₃)_{y}]₍₁₋ₓ₎(K_{0,5}Na_{0,5}NbO₃)ₓ mit 0 < x ≤ 0,12 und 0,1 ≤ y ≤ 0,5 aufweist, umfasst.

13. Bauelement nach dem vorhergehenden Anspruch, wobei der Grundkörper eine Vielzahl von gestapelten Schichten, die den keramischen Werkstoff umfassen, mit dazwischen angeordneten Elektroden umfasst, wobei die Elektroden über auf der Außenfläche des Grundkörpers angeordneten Außenelektroden elektrisch kontaktiert sind.

14. Verwendung des Bauelements nach einem der Ansprüche 12 oder 13 als Aktor.

15. Verwendung des Bauelements nach einem der Ansprüche 12 oder 13 als Sensor.

## Claims

1. Ceramic material of the formula [(Bi_{0.5}Na_{0.5}TiO₃)_{(1-y)}(BaTiO₃)_{y}]₍₁₋ₓ₎(K_{0.5}Na_{0.5}NbO₃)ₓ where 0 < x ≤ 0.12 and 0.1 ≤ y ≤ 0.5.

2. Material according to the preceding claim, said material being lead-free.

3. Material according to either of the preceding claims, where x = 0.09 and y = 0.2.

4. Material according to either of Claims 1 and 2, where x = 0.085 and y = 0.3.

5. Material according to either of Claims 1 and 2, where x = 0.075 and y = 0.4.

6. Material according to either of Claims 1 and 2, where x = 0.07 and y = 0.5.

7. Material according to either of Claims 1 and 2, where x = 0.06 and y = 0.1.

8. Method for producing a ceramic material of the formula
[(Bi_{0.5}Na_{0.5}TiO₃)_{(1-y)}(BaTiO₃)_{y}]₍₁₋ₓ₎(K_{0.5}Na_{0.5}NbO₃) where 0 < x ≤ 0.12 and 0.1 ≤ y ≤ 0.5, said method comprising the following steps:
A) pulverulent oxygen-containing compounds of Bi, Na, K, Ti, Ba and Nb are mixed in a stoichiometric ratio to produce a starting mixture,
B) the starting mixture is ground and calcined to produce a pulverulent solid solution, and
C) the pulverulent solid solution is pressed and sintered.

9. Method according to the preceding claim, wherein, in method step A), starting materials are selected from a group comprising oxides and carbonates of Bi, Na, K, Ti, Ba and Nb.

10. Method according to either of Claims 8 and 9, wherein, in method step B), the starting mixture is ground in a solvent, dried and calcined at a temperature in the range of 800°C to 950°C.

11. Method according to one of Claims 8 to 10, wherein, in method step C), the ground pulverulent solid solution is pressed to form disks and sintered at a temperature in the range of 1150°C to 1200°C.

12. Component comprising at least one ceramic basic body and at least two electrodes arranged on the basic body, wherein the basic body comprises a ceramic material of the formula
[(Bi_{0.5}Na_{0.5}TiO₃)_{(1-y)}(BaTiO₃)_{y}]₍₁₋ₓ₎(K_{0.5}Na_{0.5}NbO₃)ₓ, where 0 < x ≤ 0.12 and 0.1 ≤ y ≤ 0.5.

13. Component according to the preceding claim,
wherein the basic body comprises a multiplicity of stacked layers, which comprise the ceramic material, with electrodes arranged therebetween, wherein the electrodes are electrically contacted via external electrodes arranged on the outer surface of the basic body.

14. Use of Component according to either of Claims 12 and 13 as an actuator.

15. Use of Component according to either of Claims 12 and 13 as a sensor.

## Revendications

1. Matériau céramique, présentant la formule [(Bi_{0,5}Na_{0,5}TiO₃)_{(1-y)}(BaTiO₃)_{y}]₍₁₋ₓ₎(K_{0,5}Na_{0,5}NbO₃)ₓ avec 0 < x ≤ 0,12 et 0,1 ≤ y ≤ 0,5.

2. Matériau selon la revendication précédente, qui est exempt de plomb.

3. Matériau selon l'une quelconque des revendications précédentes, dans lequel x = 0,09 et y = 0,2.

4. Matériau selon l'une quelconque des revendications 1 ou 2, dans lequel x = 0,085 et y = 0,3.

5. Matériau selon l'une quelconque des revendications 1 ou 2, dans lequel x = 0,075 et y = 0,4.

6. Matériau selon l'une quelconque des revendications 1 ou 2, dans lequel x = 0,07 et y = 0,5.

7. Matériau selon l'une quelconque des revendications 1 ou 2, dans lequel x = 0,06 et y = 0,1.

8. Procédé de fabrication d'un matériau céramique qui présente la formule
[(Bi_{0,5}Na_{0,5}TiO₃)_{(1-y)}(BaTiO₃)_{y}]₍₁₋ₓ₎(K_{0,5}Na_{0,5}NbO₃)ₓ avec 0 < x ≤ 0,12 et 0,1 ≤ y ≤ 0,5, comprenant les étapes de procédé suivantes :
A) le mélange de composés oxygénés de Bi, Na, K, Ti, Ba et Nb en poudre selon le rapport stoechiométrique pour la fabrication d'un mélange de départ,
B) le broyage et la calcination du mélange de départ pour la fabrication d'une solution solide en poudre,
C) la compression et le frittage de la solution solide en poudre.

9. Procédé selon la revendication précédente, dans lequel les matériaux de départ à l'étape de procédé A) sont choisis dans un groupe comprenant les oxydes et les carbonates de Bi, Na, K, Ti, Ba et Nb.

10. Procédé selon l'une quelconque des revendications 8 ou 9, dans lequel le mélange de départ à l'étape de procédé B) est broyé dans un solvant, séché et calciné dans une plage de températures allant de 800 °C à 950 °C.

11. Procédé selon l'une quelconque des revendications 8 à 10, dans lequel, à l'étape de procédé C), la solution solide en poudre broyée est comprimée en plaques et frittée à une température comprise dans une plage allant de 1 150 °C à 1 200 °C.

12. Composant, qui comprend au moins un corps de base céramique et au moins deux électrodes agencées sur le corps de base, le corps de base comprenant un matériau céramique qui présente la formule
[(Bi_{0,5}Na_{0,5}TiO₃)_{(1-y)}(BaTiO₃)_{y}]₍₁₋ₓ₎(K_{0,5}Na_{0,5}NbO₃)ₓ avec 0 < x ≤ 0,12 et 0,1 ≤ y ≤ 0,5.

13. Composant selon la revendication précédente, dans lequel le corps de base comprend une pluralité de couches empilées, qui comprennent le matériau céramique, avec des électrodes agencées entre elles, les électrodes étant en contact électrique par le biais d'électrodes extérieures agencées sur la surface extérieure du corps de base.

14. Utilisation du composant selon l'une quelconque des revendications 12 ou 13 en tant qu'actionneur.

15. Utilisation du composant selon l'une quelconque des revendications 12 ou 13 en tant que capteur.
